(19) Europäisches Patentamt

European Patent Office

Office européen des brevets

(11) Veröffentlichungsnummer: **0 207 528 B1**

# (12) EUROPÄISCHE PATENTSCHRIFT

(45) Veröffentlichungstag der Patentschrift: **10.06.92**

(51) Int. Cl.⁵: **G03F 1/08**

(21) Anmeldenummer: **86109146.0**

(22) Anmeldetag: **04.07.86**

(54) **Verfahren zum Herstellung einer Lichtmaske.**

(30) Priorität: **05.07.85 DE 3524176**

(43) Veröffentlichungstag der Anmeldung:
**07.01.87 Patentblatt  87/02**

(45) Bekanntmachung des Hinweises auf die
Patenterteilung:
**10.06.92 Patentblatt  92/24**

(84) Benannte Vertragsstaaten:
**AT BE CH DE FR GB IT LI NL SE**

(56) Entgegenhaltungen:
**GB-A- 1 217 169**

**IBM TECHNICAL DISCLOSURE, Band 12, Nr.
2, Juli 1969, Seite 332, New York, US; M.H.
BRODSKY: "Image recording on amorphous
films"**

**CHEMICAL ABSTRACTS, Band 96, Nr 14,
April 1982, Seite 640, Zusammenfassung Nr.
113548k, Columbus, Ohio, US; & JP-A-81 110
939 (CHO LSI GIJUTSU KENKYU KUMIAI)
02-09-1981**

(73) Patentinhaber: **Max-Planck-Gesellschaft zur
Förderung der Wissenschaften e.V.
Bunsenstrasse 10
W-3400 Göttingen(DE)**

(72) Erfinder: **Kalbitzer, Siegfried, Dr. Phys.
Bahofweg 2
W-6900 Heidelberg(DE)**

(74) Vertreter: **von Bezold, Dieter, Dr. et al
Dr. Dieter von Bezold Dipl.-Ing. Peter Schütz
Dipl.-Ing. Wolfgang Heusler Brienner Strasse
52
W-8000 München 2(DE)**

CHEMICAL ABSTRACTS, Band 47, Nr. 22, 25. November 1953, Zusammenfassung Nr. 12068B, Columbus, Ohio, US; P. SELENYI: "Production of photographic images on selenium by crystallization under the influence of light", & ACTA PHYS. ACAD. SCI. HUNG. 2, 129-39(1952)

IBM TECHNICAL DISCLOSURE BULLTIN, Band 16, Nr. 3, August 1973, Seite 869, New York, US; P. CHAUDHARI et al.: "Electron-beam addressable memory by solid-state transformation"

IBM TECHNICAL DISCLOSURE BULLETIN, Band 14, Nr. 10 März 1972, Seiten 3133-3134, New York, US; D. AST et al.: "Producing microscopic patterns on chalcogenide films"

PROCEEDING OF THE SIPD, Band 13, Nr. 24, 1972, Seiten 188-192, New York, US; S.R. OVSHINSKY et al.: "Reversible high speed high resolution imaging in amorphous semi-conductors"

PATENT ABSTRACTS OF JAPAN, Band 4, Nr. 168 (P-37) [650], 20. November 1980; & JP-A-55 113 047 (NIPPON DENKI K.K.) 01-09-1980

PATENT ABSTRACTS OF JAPAN, Band 5, Nr. 30 (E-47) [702], 24. Februar 1981; & JP-A-55 158 635 (CHO LSI GIJUTSU KENKYU KUMIAI) 10-12-1980

PATENT ABSTRACTS OF JAPAN, Band 7, Nr. 67 (P-184) [1212], 19. März 1983; & JP-A-57 212 447 (SANYO DENKI K.K.) 27-12-1982

**Beschreibung**

Die vorliegende Erfindung betrifft ein Verfahren zum Herstellen einer Lichtmaske oder Schablone, welche Bereiche unterschiedlicher optischer Transmission enthält und welche beispielsweise bei der Herstellung von Halbleitereinrichtungen, wie integrierten Schaltungen und dergl. verwendet werden kann.

Bei der Herstellung von Halbleitereinrichtungen, wie integrierten Schaltungen, Halbleiterspeichern und dergl. werden Lichtmasken sowohl in Form von gegenüber dem herzustellenden Muster vergrößerten Schablonen (sogenannten Reticles) als auch als Kopierschablonen in Originalgröße (1:1-Schablonen) verwendet.

Die bekannten Masken werden meistens auf photolithographischem Wege durch Ätzen einer mit Photolack räumlich selektiv abgedeckten Metallschicht hergestellt. Dieses Verfahren enthält eine erhebliche Anzahl von zum Teil naßchemischen Arbeitsgängen und ist daher relativ aufwendig.

Aus Chemical Abstracts, Band 96, Nr. 14, April 1982, Seite 640, Zusammenfassung Nr. 113548k ist eine Photomaske bekannt, welche ein Substrat aus Quarz oder Saphir mit polierter Oberfläche enthält, auf dem ein Maskenmuster aus amorphem oder polykristallinem oder monokristallinem Silizium angeordnet ist, welches mit einer $Si_3N_4$-Schicht überzogen ist.

Das IBM Technical Disclosure Bulletin, Band 12, Nr. 2, Juli 1969, Seite 332, New York, US beschreibt ein Verfahren zum Aufzeichnen von gegebenenfalls mehrfarbigen Bildern mittels eines Elektronenstrahles auf einer Schicht aus amorphem Silizium. Das amorphe Silizium wird durch den Elektronenstrahl erhitzt, so daß es kristallisiert und dadurch einen Zustand höherer Transparenz annimmt. Durch Erhitzen und abruptes Abkühlen soll der amorphe Zustand wieder hergegestellt werden können, was jedoch praktisch nicht möglich ist, wie neuere Forschungen gezeigt haben.

Aus IBM Technical Disclosure Bulletin, Band 16, Nr. 3, August 1973, S. 869 ist ein durch einen Elektronenstrahl adressierbarer Speicher bekannt, bei dem Information dadurch gespeichert wird, daß der Kristallzustand eines Materials bei niedriger Temperatur durch eine Festkörperumwandlung von kristallin in amorph umgewandelt wird. Zum Löschen wird entweder ein Elektronenstrahl mit höherer Intensität als beim Schreiben verwendet oder das Material thermisch rekristallisiert. Für die Speicherschicht wird ein Material mit Kettenbindungen verwendet, wie Selen oder Polymer. Durch die Bestrahlung mit Elektronen werden die Kettenbindungen zerstört und das Material dadurch amorphisiert.

Der in den Ansprüchen gekennzeichneten Erfindung liegt, ausgehend von diesem Stand der Technik, die Aufgabe zugrunde, ein Verfahren zum Herstellen einer Lichtmaske anzugeben, das einfach ist und Muster mit Strukturlängen im Submikronbereich zu erzeugen gestattet.

Durch die Erfindung wird also ein einfaches Verfahren zum Herstellen einer solchen Lichtmaske angegeben, welches bei Verwendung geeigneter Ausgangsmaterialien nur einen einzigen Verfahrensschritt erfordert und äußerst feine Strukturen bis herunter in den Submikronbereich ohne naßchemische Prozesse herzustellen gestattet. Ein weiterer Vorteil des vorliegenden Verfahrens besteht darin, daß die Expositionsdosis im Vergleich zu Elektronenstrahlbelichtung von Photolack um den Faktor 100 kürzer ist.

Ein besonderer Vorteil der Verwendung von Ionenstrahlen besteht darin, daß diese die erforderliche Modifikation der Siliciumschicht durch geeignete Bemessung der Beschleunigungsenergie der Ionen und der Bestrahlungsdosis bis zu einer gewünschten Tiefe der Schicht in ausreichender Stärke durchzuführen gestatten. Weiterhin ist der Amorphisierungsprozeß weitgehend dosisratenunabhängig. Das ist bei anderen Strahlungsquellen, wie etwa Elektronenstrahlungsquellen oder Laser nicht der Fall. Sie können jedoch ebenfalls verwendet werden, wenn bestimmte Anforderungen an Strahlleistung und Zeitstruktur erfüllt sind. Umgekehrt kann aber auch der Phasenübergang aus einem ursprünglich amorphen Maskenmaterial in den kristallinen Zustand erfolgen, wenn andere, der jeweiligen Strahlungsart entsprechende Bestrahlungparameter eingestellt werden.

Im folgenden werden Ausführungsbeispiele der Erfindung unter Bezugnahme auf die Zeichnungen näher erläutert.

Es zeigen:

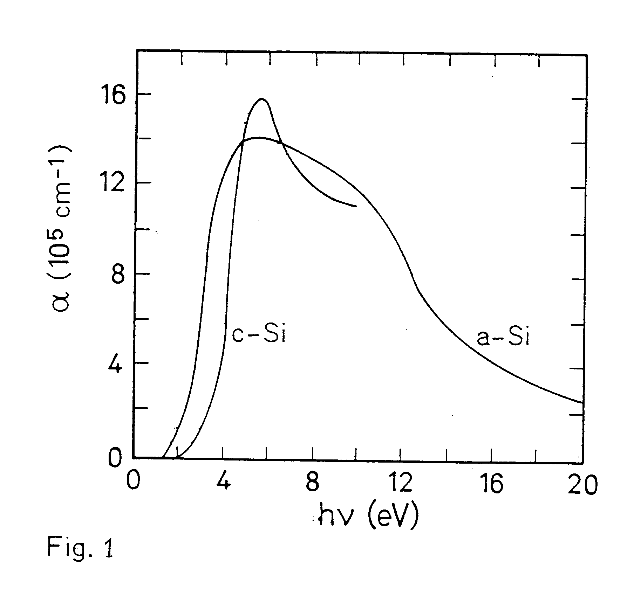

Fig. 1     die Transmissionskoeffizienten von kristallinem Silizium (c-Si) und amorphem Silicium (a-Si) und

Fig. 2     eine schematische Darstellung der Verfahrensschritte, die bei einem bekannten photolithographischen Verfahren bzw. einem Ionographie-Verfahren gemäß der Erfindung zur Herstellung einer erfindungsgemäßen Belichtungsmaske erforderlich sind.

Eine Lichtmaste, die ein transparentes Substrat und eine auf diesem angeordnete Schicht mit Bereichen unterschiedlicher Transparenz enthält, läßt sich schnell und einfach durch selektive Bestrahlung einer Schicht aus kristallinem Silicium mit Ionenstrahlungs erzeugen. Bei dieser Strahlungsart läßt sich der Schreibstrahl sehr fein fokussieren, so daß in der Siliciumschicht sehr feine Strukturen mit Dimensionen bis herab in den Submikronbereich hergestellt werden können. Entsprechendes gilt selbstverständlich auch für andere Maskenmaterialien als Silicium.

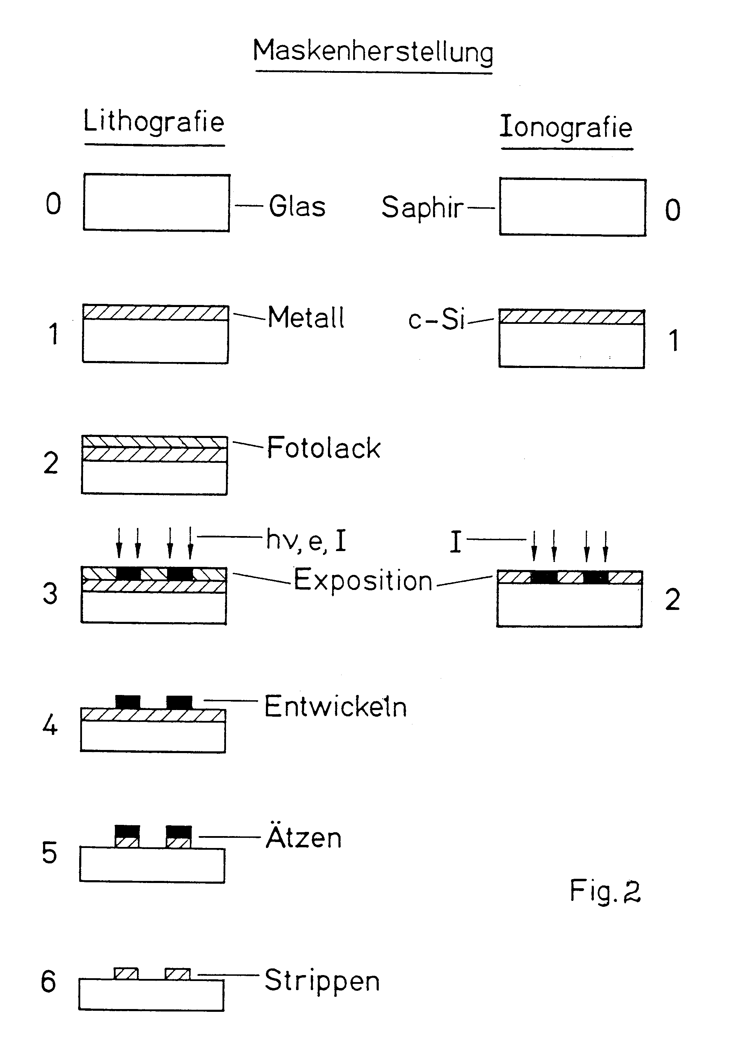

Es ist bekannt, daß amorphes Silicium (a-Si) in bestimmten Wellenlängenbereichen einen wesentlich anderen Absorptionskoeffizienten $\alpha$ für Licht hat als kristallines Silicium (c-Si), wie in Fig. 2 für Licht mit einer Quantenenergie bis zu etwa 20 eV dargestellt ist.

Der nutzbare Bereich einer c-Si/a-Si-Maske liegt bei etwa
2 eV < h$\nu$ < 4 eV bzw. 620 nm > $\lambda$ > 310 nm,
wenn ein Unterschied in den Absorptionskoeffizienten von mindestens einem Faktor 2 verlangt wird. Durch Anpassung der Schichtdicke (d) an die jeweiligen Kennwerte können Lichttransmissionen von $\tau_C \cong 50\%$, bei Kontrastwerten K $\cong$ 0,85 erzielt werden, was dem derzeitigen Stand der Photolacktechnik angemessen ist.

Beispiel:

$$h\nu = 3 \text{ eV}$$
$$\alpha_c = 1{,}3 \times 10^5 \text{ cm}^{-1}$$
$$\alpha_a = 7{,}0 \times 10^5 \text{ cm}^{-1}$$
$$d = 50 \text{ nm}$$
$$\tau_c = 52\%; \quad \tau_a = 3\%$$
$$\kappa = 0{,}89.$$

Falls die Anforderungen an die Belichtungsparameter gesenkt werden können, erweitert sich der nutzbare Lichtwellenlängenbereich entsprechend.

Es lassen sich also weite Bereiche des Lichtspektrums für Si und wirkungsgleiche andere Materialien mit hinreichend großen Unterschieden der Absorptionskoeffizienten für die kristalline bzw. amorphe Phase für Lichtmasken bzw. Belichtungsschablonen verwenden. Anstatt monokristallinem Silicium können auch polykristalline Schichten mit hinreichend kleinem Anteil an Strukturdefekten Verwendung finden.

Die Prozeßparameter für die Amorphisierung von c-Si mittels Ionenstrahlen, also insbesondere Dosis, Ionenart, Ionenenergie (Beschleunigungsspannung) und Temperatur des Targets sind dem Fachmann bekannt, siehe beispielsweise G. Müller und S. Kalbitzer, Phil. Mag. B 41 (1980) 307. Es sei in diesem Zusammenhange bemerkt, daß es nicht in allen Fällen erforderlich ist, Maskenschichten zu verwenden, deren Bereiche einerseits vollständig aus c-Si und andererseits vollständig aus a-Si bestehen. Die für eine ausreichende Änderung des Absorptionskoeffizienten erforderliche Modifikation einer Siliciumschicht läßt sich nämlich bereits mit Bestrahlungsdosen erreichen, die unter dem Schwellenwert liegen, bei dem eine homogene Amorphisierung des bestrahlten kristallinen Maskenmaterials eintritt. Man kann also gegebenenfalls in der Maske auch Grautöne, d.h. eine Art von Halbtonbild, erzeugen. Geht man von einer relativ dicken c-Si-Schicht aus, so können sich die a-Si-Bereiche nur bis zu einer gewissen Tiefe der c-Si-Schicht, aber nicht ganz durch diese Schicht hindurch erstrecken.

Bei der Herstellung der Maskenstruktur mit Ionenstrahlen sind im allgemeinen Beschleunigungsspannungen bis größenordnungsmäßig etwa 100 kV ausreichend um Schichten bis zu einer Tiefe von etwa 0,1 Mikrometer umzuwandeln. Die zugehörigen Flächendosen betragen für mittelschwere bis schwere Ionen (Atommasse ab etwa $10^{13}$) etwa $10^{13}$ bis $10^{14}$ Teilchen/cm$^2$ für die Amorphisierung typischer Halbleiter wie Si. Die Bestrahlung bei tieferen Temperaturen, insbesondere der Temperatur des flüssigen Stickstoffs, ist in der Regel effizienter als bei Raumtemperatur, jedoch keine Notwendigkeit. So ergeben sich beispielsweise für eine Dosis von $10^{13}$ Ar-Ionen/cm$^2$ bei Strahlströmen von 2 nA Schreibzeiten von rund $10^3$s für eine 1 cm$^2$ große Maskenfläche. Bei einem Strahldurchmesser von 0,1 Mikrometer beträgt die Expositionszeit 0,1 Mikrosekunden/Pixel.

Da a-Si erst bei Temperaturen um etwa 600°C rekristallisiert, sind die durch Bestrahlung erzeugten a-Si/c-Si-Muster bei Umgebungstemperaturen langzeitstabil.

Fig. 2 zeigt schematisch die Verfahrensschritte zur Herstellung einer Maske nach einem bekannten photolithographischen Verfahren im Vergleich zu den Verfahrensschritten bei dem erfindungsgemäßen Ionographie-Verfahren.

Bei dem bekannten Verfahren geht man von einem Glassubstrat 0 aus, das in einem ersten Verfahrensschritt 1 mit einer Metallschicht versehen wird, auf die im Verfahrensschritt 2 eine Photolackschicht aufgetragen wird. Im Verfahrensschritt 3 erfolgt dann die Exposition durch elektromagnetische, Elektronen- oder Ionenstrahlung. Im folgenden Verfahrensschritt 4 wird die Photolackschicht dann entwickelt, wobei man eine Ätzmaske auf der Metallschicht erhält, im Verfahrensschritt 5 wird die Metallschicht dann selektiv geätzt und in dem Verfahrensschritt 6 wird dann der restliche Photolack entfernt.

Bei dem erfindungsgemäßen Verfahren geht man beispielsweise von einem Saphirsubstrat aus, das in einem ersten Verfahrensschritt mit einer Schicht aus c-Si gewünschter Dicke überzogen wird. Im nächsten Verfahrensschritt erfolgt dann die Exposition mit einem fein gebündelten Ionenstrahl. Die Maske ist nun schon fertig.

Da Saphirsubstrate mit einer Schicht aus kristallinem Silicium (c-Si/Al$_2$O$_3$) als "SOS" (Silicon on Sapphire) kommerziell erhältlich sind, besteht der Prozeß der Herstellung der erfindungsgemäßen Masken in der Praxis lediglich aus der Strahlexposition, hier mittels Ionenstrahlen.

Die Erfindung ist selbstverständlich nicht auf die oben beschriebenen Ausführungsbeispiele beschränkt. Die erfindungsgemäßen, nach dem Verfahren hergestellten Masken lassen sich mit violettem Licht verwenden, auch Lichtwellenlängen bis zum nahen Ultraviolett sind gut geeignet. Als Material für die Maskenschicht kommen hier auch andere Halbleitersysteme mit dementsprechenden Bandabständen in Betracht. Es ist weiterhin klar, daß die oben beschriebene Maskenfertigung stellvertretend für optisches Strukturieren im allgemeinen steht. Das betrifft z.B. die Herstellung optischer Gerät (Gitter, Filter u.a.).

Als Maskenmaterialien können anstelle von Silicium auch andere Halbleitermaterialen verwendet werden, z. B. Germanium oder $A_{111}B_V$ -Verbindungshalbleitermaterialien, ganz allgemein sind Materialien mit geeigneter Bandlücke und kovalenter Bindung als Maskenmaterial verwendbar.

## Patentansprüche

1. Verfahren zum Herstellen einer Lichtmaske, welche eine Maskenschicht mit Bereichen unterschiedlicher optischer Transmission aus amorphem bzw. kristallinem Halbleitermaterial enthält, **dadurch gekennzeichnet,** daß die optische Transmission ausgewählter Bereiche einer dünnen Schicht aus kristallinem Halbleitermaterial durch Amorphisierung mittels eines fokussierten Ionenstrahles verringert wird.

2. Verfahren nach Anspruch 1, **dadurch gekennzeichnet,** daß man von einer Schicht aus monokristallinem Silicium ausgeht.

3. Verfahren nach Anspruch 1 oder 2, **dadurch gekennzeichnet,** daß Strahlung aus mittelschweren bis schweren Ionen, insbesondere Argonionen, verwendet wird.

4. Verfahren nach einem der Ansprüche 1 bis 3, **dadurch gekennzeichnet,** daß die Maskenschicht während der Bestrahlung gekühlt wird.

5. Verfahren nach Anspruch 2 oder den Ansprüchen 2 und 3 oder 4, **dadurch gekennzeichnet,** daß die Schicht aus dem monokristallinem Silicium auf einem Saphir-Substrat angeordnet ist.

## Claims

1. A method of manufacturing a light mask comprising a mask layer including regions which have different optical transmissions and are made of amorphous and crystalline semiconductor material, respectively, **characterized in that** the optical transmission of selected regions of a thin layer of crystalline semiconductor material is reduced by amorphization by means of a focussed ion beam.

2. The method of claim 1, **characterized in that** one starts from a layer of monocrystalline silicon.

3. The method of claim 1 or 2, **characterized in that** radiation of medium-heavy to heavy ions, such as argon ions, is used.

4. The method of any of claims 1 to 3, **characterized in that** said mask layer is chilled during the irradiation.

5. The method of claim 2 or claims 2 and 3 or 4, **characterized in that** the layer of monocrystalline silicon is supported on a sapphire substrate.

## Revendications

1. Procédé de fabrication d'un masque photo, comportant des zones à transmission optique différente, constituées de matériaux semiconducteurs amorphes ou cristallins, caractérisé en ce que la transmission optique de zones prédéterminées d'une couche fine constituée de matériaux semi-conducteurs cristallins est diminuée en rendant amorphe au moyen d'un faisceau ionique focalisé.

2. Procédé suivant la revendication 1, caractérisé en ce que l'on part d'une couche constituée de silicium monocristallin.

3. Procédé suivant la revendication 1 ou la revendication 2, caractérisé en ce que l'on utilise un faisceau d'ions mi-lourds à lourds, en particulier d'ions argon.

4. Procédé suivant l'une quelconque des revendications 1 à 3, caractérisé en ce que la couche formant masque est refroidie pendant l'irradiation.

5. Procédé suivant la revendication 2 ou les revendications 2 et 3 ou 4, caractérisé en ce que la couche constituée de silicium monocristallin est disposée sur un substrat de saphir.

Fig. 1

# Maskenherstellung

Fig. 2